# EUROPEAN PATENT SPECIFICATION

(11) **EP 4 044 235 B1**
(45) Date of publication and mention of the grant of the patent: **06.05.2026**
(21) Application number: 20876033.0
(22) Date of filing: 31.08.2020
(51) Int. Cl.: H10H 29/01, H10H 29/30, H10H 20/01, H10H 20/818, H10H 20/819, H10H 20/854

(54) **NANOWIRE-BASED µLED DISPLAY DESIGN METHOD**
VERFAHREN ZUM DESIGN EINER µLED-ANZEIGE AUF NANODRAHTBASIS
PROCÉDÉ DE CONCEPTION D'AFFICHAGE µDEL À BASE DE NANOFILS

(30) Priority: 16.10.2019 CN 201910984749
(43) Date of publication of application: 17.08.2022
(73) Proprietor: Fu Zhou University, Fuzhou, Fujian 350108 (CN); Mindu Innovation Lab, Fuzhou, Fujian 350108 (CN)
(72) Inventor: GUO, Tailiang, Fuzhou, Fujian 350108 (CN); JIANG, Zongzhao, Fuzhou, Fujian 350108 (CN); YE, Yun, Fuzhou, Fujian 350108 (CN); YAN, Qun, Fuzhou, Fujian 350108 (CN); XIE, Hongxing, Fuzhou, Fujian 350108 (CN); YAO, Jianmin, Fuzhou, Fujian 350108 (CN)
(74) Representative: Bayramoglu et al.
(86) International application number: PCT/CN2020/112403
(87) International publication number: WO 2021/073288

(56) References cited:
- WO-A2-2010/062644
- CN-A- 1 453 884
- CN-A- 102 081 194
- CN-A- 103 168 360
- CN-A- 104 916 746
- CN-A- 108 630 717
- CN-A- 110 676 283
- US-A1- 2008 001 161
- US-A1- 2011 309 354
- US-A1- 2014 338 735
- US-A1- 2015 263 066

## Description

### BACKGROUND OF THE INVENTION

### 1. Technical Field

The present invention relates to the field of LED design, particularly to a µLED display design method based on nanowire.

### 2. Description of Related Art

In the technical field of panel display, µLED has many advantages, and the most prominent advantages of µLED are low power consumption, high brightness, ultrahigh definition, high color saturation, higher response speed, longer service life, higher working efficiency and the like. It can be said that µLED is a reformed novel display technology and is expected to replace almost all TFT liquid crystal displays applied in the field of panel display.

At present, a production process of µLED still adopts a conventional LED manufacturing mode, the size of a manufactured pn junction material is defined below 100 um by way of growth of various thin films, and in the growth process of the lamellar thin films, there is unavoidably a problem of mismatch of crystal lattices, and thus, it is necessary to introduce various buffer layers or functional layers in the manufacturing process of the lamellar µLED to solve the problem of mismatch of crystal lattices and improve the quantum conversion efficiency. Therefore, the lamellar structure becomes more complex. After the µLED is manufactured, it is necessary to cut the µLED into small nano-scaled LED chips and the chips are transferred to a circuit substrate via various mechanical tools. The process takes a lot of time as it is needed to pickup, place and assemble a huge amount of µLED chips. In order to solve the above-mentioned problems so as to improve the industrial efficiency of µLED and simplify the structure, it is an urgent need to develop and design a novel µLED.

Patent US 2015/263066 A1 discloses a nanowire device and a method of forming a nanowire device that is poised for pick up and transfer to a receiving substrate are described. In an embodiment, the nanowire device includes a base layer and a plurality of nanowires on and protruding away from a first surface of the base layer. An encapsulation material laterally surrounds the plurality of nanowires in the nanowire device, such that the nanowires are embedded within the encapsulation material.

Patent US 2014/338735 A1 discloses a transparent conductor including a conductive layer coated on a substrate is described. More specifically, the conductive layer comprises a network of nanowires that may be embedded in a matrix. The conductive layer is optically clear, patternable and is suitable as a transparent electrode in visual display devices such as touch screens, liquid crystal displays, plasma display panels and the like.

### BRIEF SUMMARY OF THE INVENTION

For this purpose, the present invention is intended to provide a µLED display design method based on nanowire. The method can simplify the structure and enhance the industrial efficiency of µLED.

The present invention is realized by adopting the following scheme: a µLED display design method based on nanowire specifically includes: growing different nanowire materials capable of generating three primary colors: red, green and blue on a substrate; respectively dissolving the different nanowire materials in insulated photocuring adhesives and injecting the mixtures into different grids of a grid pool, and performing curing; and finally, arranging electrodes on upper and lower surfaces of the grid pool.

The method specifically includes the following steps:
Step S1: growing the nanowire material for generating a light source for three primary colors: red, green and blue (a craft technique of MOCVD can be utilized), performing electropositive and electronegative tendency treatment on an end, and performing peeling after growth;
Step S2: respectively doping the nanowire material for generating a light source for three primary colors: red, green and blue into the photocuring adhesives and stirring the mixtures fully (including mechanical stirring or magnetic stirring or ultrasonic stirring), and evenly dispersing the nanowire material in the photocuring adhesives to obtain a fully stirred photocuring adhesive-nanowire material adhesive body;
Step S3: respectively injecting the fully stirred photocuring adhesive-nanowire material adhesive body correspondingly into the grids of the grid pool corresponding to sub-pixels of the three primary colors: red, green and blue, and performing photocuring, and cutting off the overflowing cured adhesive bodies by way of laser cutting after photocuring to obtain sub-pixel cured µLEDs, wherein in the process of injecting an adhesive solution mixed with the red, green and blue nanowire materials, the green and blue grid pools, the red and blue grid pools and the red and green grid pools can be shielded respectively, and the overflowing cured adhesive bodies are cut off by way of laser cutting after photocuring; and
Step S4: enabling an electrode capable of working under a condition of an alternating current to be in one-to-one-correspondence with the corresponding sub-pixel cured µLEDs on the upper and lower surfaces of the grid pool by way of attaching a chip electrode or growing the electrode, and cutting off a desired display size by way of laser cutting.

The Step S1 includes the following steps:
Step S11: cleaning and treating the substrate: ultrasonically cleaning a sample in sequence in deionized water, ethanol and deionized water, removing pollutants left on the surface and blow-drying the sample;
Step S12: putting the substrate in a reaction chamber of a physical vapor deposition device and starting evaporation of a nanowire buffer layer at a certain pressure of the reaction chamber and a temperature of a metal source to solve mismatch between the substrate and the nanowire in an axial direction, wherein the nanowire releases stress-strain caused by mismatch between the substrate and crystal lattices of the nanowire material along a side surface and a direction perpendicular to a junction interface during growth, so that materials with mismatched crystal lattices can be connected in series and grow in a radial direction or an axial direction conveniently; and performing growth of an upright nanowire material after the thin film of the buffer layer grows;
Step S13: putting the substrate covered with the thin film of the buffer layer in a multi-chip HVPE growth system, starting growing the nanowire at a low temperature by taking the substrate as a bottom, and controlling a nanowire material source, n and p-doped gases, a reaction gas, a carrier gas and electropositive and electronegative tendency treatment, wherein the nanowire grows to become a structure of an electropositive tendency p-doped nanowire end-p-doped nanowire-n-doped nanowire-electronegative tendency n-doped nanowire end from bottom to top; and
Step S14: cooling the structure to take out a sample so as to obtain the nanowire material. Further, preferably, the nanowire materials are different homojunction materials of homogeneous structures which grown on the silicon substrate from bottom to top and are capable of generating three primary colors: red, green and blue, the upper and lower ends of the nanowire materials are respectively n and p-doped, two end tops are respectively in electronegative tendency and electropositive tendency, and a hole electron recombination can be generated at a center of a junction of n and p homojunctions.

Further, preferably, an inner diameter of the nanowire ranges from 40 nm to 60 nm, and a length thereof ranges from 300 nm and 400 nm, thereby providing a proper contact area for carrier recombination of the pn junction so as to perform radiative transition.

Further, preferably, for sub-pixels with different primary colors, a nanowire growth material is different direct band-gap semiconductor compounds from groups III-V.

Further, preferably, the photocuring adhesive is a transparent insulating material.

Further, preferably, the grid pool is made from a transparent insulating material.

Further, preferably, the electrode is a material capable of working under a condition of an alternating current, including, but not limited to, graphene, PEDOT: PPS, and metals silver, platinum or gold.

In conclusion, the display design of µLED of the present invention completes electron-hole recombination by utilizing the homogeneous pn junction nanowire materials to generate radiative transition. Compared with the lamellar structure, the nanowire type pn junction is lower in working voltage and higher in inner quantum efficiency. Stress-strain caused by mismatch between the substrate and crystal lattices of the nanowire can be released along the side surface and the direction perpendicular to the junction interface in the growth process of the nanowire, so that limitation by mismatch of the crystal lattices of the lamellar structure is overcome. Meanwhile, in the growth process, various micro-treatment can be performed, so that the work efficiency of the apparatus is improved. The nanowire and the photocuring adhesive are inter-dissolved and are cured in the sub-pixel grid pool after being evenly stirred, so that the structure of the lamellar µLED is simplified. When the sub-pixels are selected, electrons and holes in the insulating photocuring adhesive complete short-distance transition via quantum tunneling and are injected into the nanowire, so that the pn junction generates radiative transition. The end of the nanowire is in electropositive and electronegative tendencies to guide carriers. Thus, the µLED of the structure can work in the state of the alternating current, and the desired display size can be obtained by way of laser cutting, so that there is no problem of massive transfer, the manufacturing period of the µLED is shortened, and the market competitiveness of the µLED is improved greatly.

Compared with the prior art, the present invention has the following beneficial effects:
1. According to the display design method of the µLED provided by the present invention, the sub-pixels are lightened as the carrier recombination of the pn junction of the nanowire material of emits light; different from planar growth of a conventionalµLED, the semiconductor nanowire can release stress-strain caused by mismatch between the substrate and crystal lattices of the nanowire material along the side surface and the direction perpendicular to the junction interface during growth, so that the semiconductor nanowire can grow on a specific substrate to overcome limitation caused by mismatch of the crystal lattices, and can further be designed in various complicated structures conveniently;
2. As the current of a junction array in the nanowire shape is greater than the current of the lamellar junction, the design reduces the working voltage as well. The photocuring adhesives and the nanowires mixed in the grid pool are photocured to form the sub-pixel points, so that the µLED features simple and easily implemented manufacturing process and simpler structure as well.
3. The grids are cut by way of laser cutting, and thus, the desired display size can be obtained, so that there is no problem of massive transfer of the conventional µLED for display industry.

### BRIEF DESCRIPTION OF THE SEVERAL VIEWS OF THE DRAWINGS

FIG. 1 is a sectional schematic diagram of a µLED display structure designed by a design method in an embodiment of the present invention.
FIG. 2 is a sectional schematic diagram of a nanowire in an embodiment of the present invention.
FIG. 3 is a structural schematic diagram of a grid pool in an embodiment of the present invention.
FIG. 4 is a diagram of a mixed solution of a photocuring adhesive and a nanowire in an embodiment of the present invention.
FIG. 5 is a flow schematic diagram of a method in an embodiment of the present invention.

In the drawings, 10-red µLED; 11-substrate; 12-buffer layer; 13-end of nanowire with electropositive tendency; 14-p-type doped nanowire material; 15-nanowire; 16-n-type doped nanowire material; 17-end of nanowire with electronegative tendency; 20-green µLED; 25-photocuring adhesive; 30-blue µLED; 40-grid pool; 50-insulating part of electrode; 60-electrode.

### DETAILED DESCRIPTION OF THE INVENTION

Further description of the present invention will be made below in combination with drawings and embodiments.

It is to be noted that the detailed description below is exemplary and is intended to further describe the application. Unless specified otherwise, all technical and scientific terms used herein have the same meaning as commonly understood by those of ordinary skill in the art to which the application belongs.

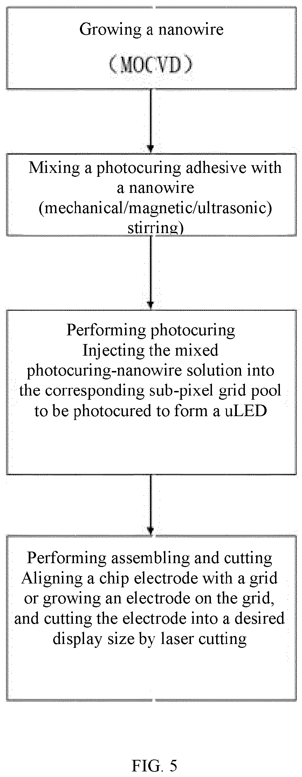

It is to be noted that the terms used herein are merely to describe specific implementation modes rather than being intended to limit the exemplary implementation modes according to the application. As used herein, unless otherwise specified in the context, the singular form is further intended to include plural form. In addition, it is to be further understood that when the terms "comprise" and/or "include" are used in the description, it indicates that there are features, steps, operations, apparatuses, assemblies and/or their combinations. As shown in FIG. 5, the embodiment provides a µLED display design method based on nanowire. The method specifically includes: growing different nanowire materials capable of generating three primary colors: red, green and blue on a substrate; respectively dissolving the different nanowire materials in insulated photocuring adhesives and injecting the mixtures into different grids of a grid pool, and performing curing; and finally, arranging electrodes on upper and lower surfaces of the grid pool. When an addressing signal passes through the corresponding electrode, lightening of corresponding pixels and image display can be completed.

In the embodiment, the method specifically includes the following steps:
Step S1: a nanowire material for generating a light source for three primary colors: red, green and blue (a craft technique of MOCVD can be utilized) grows, electropositive and electronegative tendency treatment is performed on an end, and peeling is performed after growth;
Step S2: the nanowire material for generating a light source for three primary colors: red, green and blue is respectively doped into the photocuring adhesives and the mixtures are fully stirred (including mechanical stirring or magnetic stirring or ultrasonic stirring), and the nanowire material in the photocuring adhesives is evenly dispersed to obtain a fully stirred photocuring adhesive-nanowire material adhesive body;
Step S3: the fully stirred photocuring adhesive-nanowire material adhesive body is respectively and correspondingly injected into the grids of the grid pool corresponding to sub-pixels of the three primary colors: red, green and blue, and performing photocuring, and the overflowing cured adhesive bodies are cut off by way of laser cutting after photocuring to obtain sub-pixel cured µLEDs, wherein in the process of injecting an adhesive solution mixed with the red, green and blue nanowire materials, the green and blue grid pools, the red and blue grid pools and the red and green grid pools can be shielded respectively, and the overflowing cured adhesive bodies are cut off by way of laser cutting after photocuring; and
Step S4: an electrode capable of working under a condition of an alternating current is enabled to be in one-to-one-correspondence with the corresponding sub-pixel cured µLEDs on the upper and lower surfaces of the grid pool by way of attaching a chip electrode or growing the electrode, and a desired display size is cut off by way of laser cutting.

In the embodiment, the nanowire materials are different homojunction materials of homogeneous structures which grown on the silicon substrate from bottom to top and are capable of generating three primary colors: red, green and blue, the upper and lower ends of the nanowire materials are respectively n and p-doped, two end tops are respectively in electronegative tendency and electropositive tendency, and a hole electron recombination can be generated at a center of a junction of n and p homojunctions.

In the embodiment, an inner diameter of the nanowire ranges from 40 nm to 60 nm, and a length thereof ranges from 300 nm and 400 nm, thereby providing a proper contact area for carrier recombination of the pn junction so as to perform radiative transition.

In the embodiment, the S1 includes the following steps:
Step S11: the substrate is cleaned and treated: a sample is ultrasonically cleaned in sequence in deionized water, ethanol and deionized water, pollutants left on the surface are removed and the sample is blow-dried;
Step S12: the substrate is put in a reaction chamber of a physical vapor deposition device and evaporation of a nanowire buffer layer is started at a certain pressure of the reaction chamber and a temperature of a metal source to solve mismatch between the substrate and the nanowire in an axial direction, wherein the nanowire releases stress-strain caused by mismatch between the substrate and crystal lattices of the nanowire material along a side surface and a direction perpendicular to a junction interface during growth, so that materials with mismatched crystal lattices can be connected in series and grow in a radial direction or an axial direction conveniently; and performing growth of an upright nanowire material after the thin film of the buffer layer grows;
Step S13: the substrate covered with the thin film of the buffer layer is putt in a multi-chip HVPE growth system, growing the nanowire is started at a low temperature by taking the substrate as a bottom, and a nanowire material source, n and p-doped gases, a reaction gas, a carrier gas and electropositive and electronegative tendency treatment are controlled, wherein the nanowire grows to become a structure of an electropositive tendency p-doped nanowire end-p-doped nanowire-n-doped nanowire-electronegative tendency n-doped nanowire end from bottom to top; and
Step S14: the structure s cooled to take out a sample so as to obtain the nanowire material.

In the embodiment, for sub-pixels with different primary colors, a nanowire growth material is different direct band-gap semiconductor compounds from groups III-V. For example, blue light emitting sub-pixels are GaN, green light emitting sub-pixels are InGaN, red light emitting sub-pixels are GaAs, which is not limited thereto.

In the embodiment, the photocuring adhesive is a transparent insulating material. The photocuring adhesive, as a carrier for different nanowire materials with red, green and blue sub-pixels, is an adhesive body at a room temperature and a normal pressure, has certain mobility and can be cured at room temperature. The photocuring adhesive is the transparent insulating material with a great dielectric constant so as to realize transparent display.

The photocuring adhesive material can be used for preparing the transparent insulating photocuring adhesive capable of being quickly cured by ultraviolet light at room temperature from a main component of an oligomer of an unsaturated polyester resin, an acrylic resin and a polythiol/polyenoid resin matched with a proper diluent monomer, a photosensitizer and an auxiliary material.

In the embodiment, the grid pool is made from a transparent insulating material. The grid pool is taken as a place where a mixed solution of the photocuring adhesive and the nanowire materials is cured, and meanwhile, each of the grids is taken as a red, green and blue sub-pixel point. The grid pool is the transparent insulating material with a great dielectric constant to realize transparent display.

The electrodes are set as conducting electrodes with sub-pixel units in different primary color at an interval in sequence, and the sizes and the center positions of the electrodes are precisely matched with the sizes and the center positions of the grid pool.

In the embodiment, the grids of the grid pool are shaped like a Chinese character "kou", with a length ranged from 16 um to 32 um, a width ranged from 9 um to 18 um and a depth ranged from 9 um to 18 um, wherein a distance between the outer wall of the grid wall and the grid pool ranges from 1 um to 3 um. The transmittance for rays with wavelengths ranged from 380 nm to 780 nm is greater than or equal to 90%. The material can be an organic material, including one or more of polyethylene (PE), polypropylene (PP), polyethylene naphthalate (PEN), polycarbonate (PC), polymethyl acrylate (PMA), polymethyl methacrylate (PMMA), cellulose acetate butyrate (CAB), siloxane, polyvinyl chloride (PVC), polyvinyl alcohol (PVA), polyethylene terephthalate (PET), polyethylene terephthalate glycol (PETG), polydimethylsiloxane (PDMS) or a cycloene copolymer (COC); or an inorganic material, including one or more of glass, quartz and a transmission ceramic material.

In the embodiment, the electrode is a material capable of working under a condition of an alternating current, including, but not limited to, graphene, PEDOT: PPS, and metals silver, platinum or gold. The electrode can be either a chip electrode or a transparent electrode material growing on the µLED subsequently. As the nanowires in the µLED in the design are evenly distributed in the adhesive body, distribution of p-end nanowires and n-end nanwores is unknown, so that the electrode material is a material capable of working under a condition of an alternating current so as to enable the carrier recombination of the pn junction to emit light.

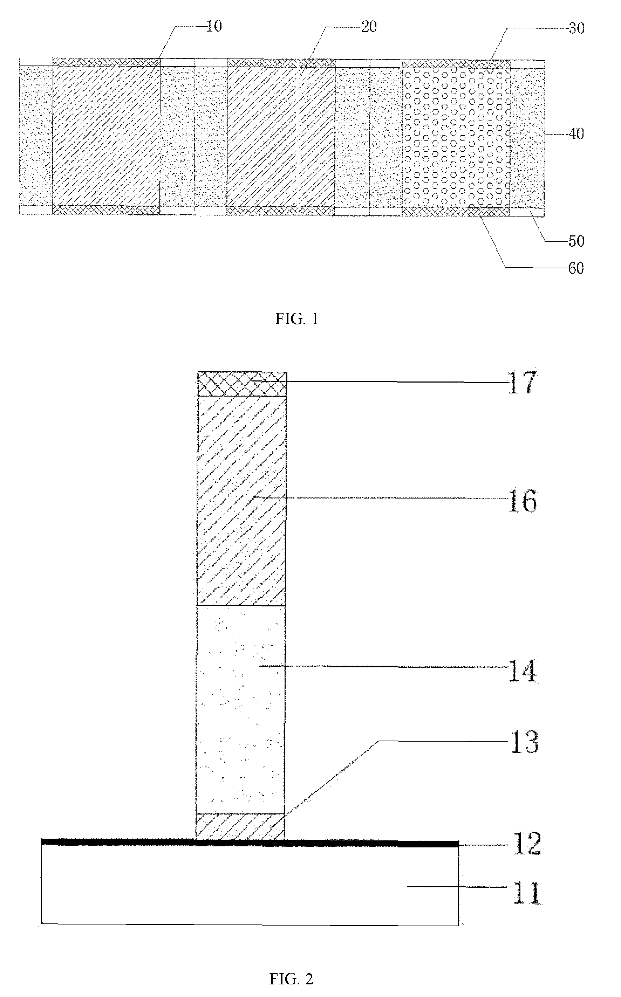

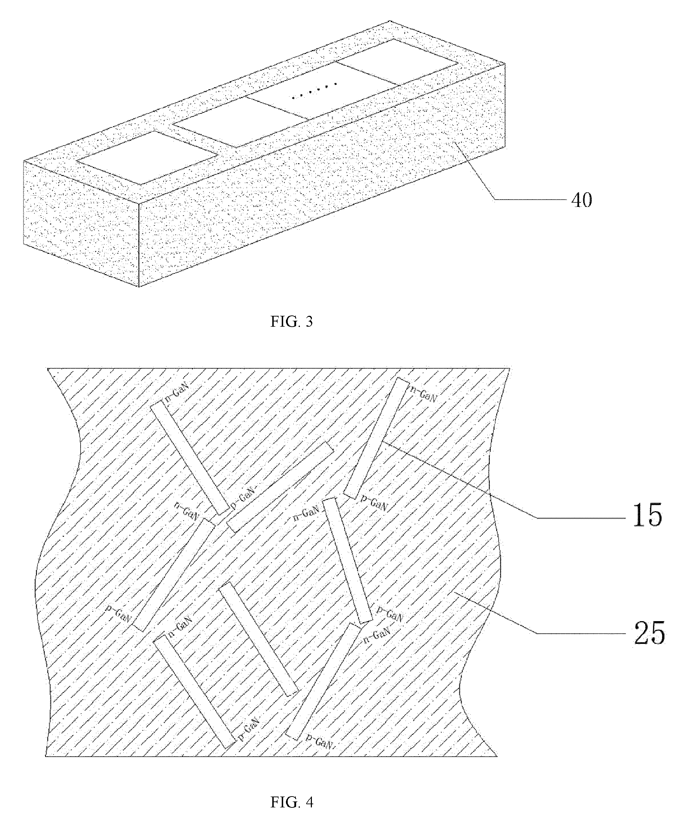

As shown in FIG. 1, 10 is the red µLED, 20 is the green µLED, 30 is the blue µLED, 40 is the grid pool, 50 is the insulating part of the electrode, and 60 is the electrode. The nanowire materials for the red, green and blue µLEDs are respectively GaN, InGaN and GaAs, the electrode is the chip electrode, the insulating part is silicon dioxide, and the conducting part is Ag. As shown in FIG. 2, the nanowire grows on the substrate 11 which is silicon. The buffer layer (made from AlN) 12, the end of the nanowire with electropositive tendency 13, the p-type doped nanowire material 14, the n-type doped nanowire material 16 and the end of the nanowire with electronegative tendency 17 grow in sequence on the silicon substrate by way of MOCVD. The nanowire material is peeled centrifugalized after growth. As shown in FIG. 3, 40 is the grid pool distributed in a rectangular shape of Chinese character "kou", with a thickness of 1 um. Each of the grids is 16 um long, 9 um wide and 9 um deep. The grid is made from a transparent silicon dioxide insulating material, and the light transmittance is greater than 90%. As shown in FIG. 4, 15 is nanowire, and 25 is photocuring adhesive which is a µV photocuring adhesive based on epoxy methacrylate resin. The carbon nanowire is evenly dispersed in the adhesive by mechanically stirring the centrifugally separated nanowire and the uV adhesive and the mixture is ultraviolet-cured to form a single primary color sub-pixel µLED.

In conclusion, the display design of µLED of the embodiment completes electron-hole recombination by utilizing the homogeneous pn junction nanowire materials to generate radiative transition. Compared with the lamellar structure, the nanowire type pn junction is lower in working voltage and higher in inner quantum efficiency. Stress-strain caused by mismatch between the substrate and crystal lattices of the nanowire can be released along the side surface and the direction perpendicular to the junction interface in the growth process of the nanowire, so that limitation by mismatch of the crystal lattices of the lamellar structure is overcome. Meanwhile, in the growth process, various micro-treatment can be performed, so that the work efficiency of the apparatus is improved. The nanowire and the photocuring adhesive are inter-dissolved and are cured in the sub-pixel grid pool after being evenly stirred, so that the structure of the lamellar µLED is simplified. When the sub-pixels are selected, electrons and holes in the insulating photocuring adhesive complete short-distance transition via quantum tunneling and are injected into the nanowire, so that the pn junction generates radiative transition. The end of the nanowire is in electropositive and electronegative tendencies to guide carriers. Thus, the µLED of the structure can work in the state of the alternating current, and the desired display size can be obtained by way of laser cutting, so that there is no problem of massive transfer, the manufacturing period of the µLED is shortened, and the market competitiveness of the µLED is improved greatly.

The above is merely preferred embodiments of the present invention and is not limitation to the present invention in other forms. Those skilled in the art may alter or modify equivalent embodiments with equivalent changes by means of the disclosed technical content. Any subtle modifications, equivalent changes and modifications made on the embodiments in accordance with the technical substance of the present invention shall come within the scope of the technical scheme of the present invention without departing the content of the technical scheme of the present invention.

## Claims

1. A µLED display design method based on nanowire, comprising: growing different nanowire materials capable of generating three primary colors: red, green and blue on a substrate (11); and **characterized in that** the method further comprises: respectively dissolving the different nanowire materials in insulated photocuring adhesives and injecting the mixtures into different grids of a grid pool (40), and performing curing; and finally, arranging electrodes (60) on upper and lower surfaces of the grid pool (40);
the µLED display design method based on nanowire specifically comprising the following steps:
Step S1: growing the nanowire material for generating a light source for three primary colors: red, green and blue;
Step S2: respectively doping the nanowire material for generating a light source for three primary colors: red, green and blue into the photocuring adhesives and stirring the mixtures fully, and evenly dispersing the nanowire material in the photocuring adhesives to obtain a fully stirred photocuring adhesive-nanowire material adhesive body;
Step S3: respectively injecting the fully stirred photocuring adhesive-nanowire material adhesive body correspondingly into the grids of the grid pool (40) corresponding to sub-pixels of the three primary colors: red, green and blue, and performing photocuring, and cutting off the overflowing cured adhesive bodies by way of laser cutting after photocuring to obtain sub-pixel cured µLEDs; and
Step S4: enabling an electrode capable of working under a condition of an alternating current to be in one-to-one-correspondence with the corresponding sub-pixel cured µLEDs on the upper and lower surfaces of the grid pool (40) by way of attaching a chip electrode or growing the electrode, and cutting off a desired display size by way of laser cutting;
the Step S1 comprises the following steps:
Step S11: cleaning and treating a substrate (11);
Step S12: putting the substrate (11) in a reaction chamber of a physical vapor deposition device and starting evaporation of a nanowire buffer layer (12) to solve mismatch between the substrate and the nanowire in an axial direction, wherein the nanowire releases stress-strain caused by mismatch between the substrate and crystal lattices of the nanowire material along a side surface and a direction perpendicular to a junction interface during growth, so that materials with mismatched crystal lattices can be connected in series and grow in a radial direction or an axial direction conveniently;
Step S13: putting the substrate (11) covered with a thin film of the buffer layer (12) in a multi-chip HVPE growth system, starting growing the nanowire at a low temperature by taking the substrate as a bottom, wherein the nanowire grows to become a structure of an electropositive tendency p-doped nanowire end-p-doped nanowire-n-doped nanowire-electronegative tendency n-doped nanowire end from bottom to top; and
Step S14: cooling the structure to take out a sample so as to obtain the nanowire material.

2. The µLED display design method based on nanowire according to claim 1, wherein the nanowire material is of a homogeneous structure, the upper and lower ends of the nanowire material are respectively n and p-doped, two end tops are respectively in electronegative tendency and electropositive tendency, and a hole electron recombination can be generated at a center of a junction of n and p homojunctions.

3. The µLED display design method based on nanowire according to claim 1, wherein an inner diameter of the nanowire ranges from 40 nm to 60 nm, and a length thereof ranges from 300 nm and 400 nm.

4. The µLED display design method based on nanowire according to claim 1, wherein for sub-pixels with different primary colors, a nanowire growth material is different direct band-gap semiconductor compounds from groups III-V.

5. The µLED display design method based on nanowire according to claim 1, wherein the photocuring adhesive is a transparent insulating material.

6. The µLED display design method based on nanowire according to claim 1, wherein the grid pool (40) is made from a transparent insulating material.

7. The µLED display design method based on nanowire according to claim 1, wherein the electrode (60) is a material capable of working under a condition of an alternating current, including, but not limited to, graphene, PEDOT: PPS, and metals silver, platinum or gold.

## Patentansprüche

1. Verfahren zur Gestaltung einer µLED-Anzeige auf Nanodrahtbasis, umfassend: Wachsenlassen unterschiedlicher Nanodrahtmaterialien, die fähig sind, die drei Primärfarben Rot, Grün und Blau auf einem Substrat (11) zu erzeugen, **dadurch gekennzeichnet, dass** das Verfahren ferner Folgendes umfasst: jeweils Lösen der unterschiedlichen Nanodrahtmaterialien in isolierenden, lichthärtenden Klebstoffen und Injizieren der Mischungen in unterschiedliche Gitter einer Gitteraufnahme (40) sowie Durchführen der Aushärtung und schließlich Anordnen von Elektroden (60) auf oberen und unteren Oberflächen der Gitteraufnahme (40),
wobei das Verfahren zur Gestaltung einer µLED-Anzeige auf Nanodrahtbasis insbesondere die folgenden Schritte umfasst:
Schritt S1: Wachsenlassen des Nanodrahtmaterials, um eine Lichtquelle für die drei Primärfarben Rot, Grün und Blau zu erzeugen;
Schritt S2: jeweils Dotieren des Nanodrahtmaterials, um eine Lichtquelle für die drei Primärfarben Rot, Grün und Blau zu erzeugen, in die lichthärtenden Klebstoffe und vollständiges Durchrühren der Mischungen sowie gleichmäßiges Dispergieren des Nanodrahtmaterials in den lichthärtenden Klebstoffen, um einen vollständig durchmischten Klebstoffkörper aus lichthärtendem Klebstoff und Nanodrahtmaterial zu erhalten;
Schritt S3: jeweils Injizieren des vollständig durchmischten Klebstoffkörpers aus lichthärtendem Klebstoff und Nanodrahtmaterial entsprechend in die Gitter der Gitteraufnahme (40) entsprechend den Subpixeln der drei Primärfarben Rot, Grün und Blau und Durchführen von Lichthärten und Abtrennen der überflüssigen ausgehärteten Klebstoffkörper durch Laserschneiden nach dem Lichthärten, um µLEDs zu erhalten, deren Subpixel ausgehärtet sind, und
Schritt S4: Ermöglichen, dass eine Elektrode, die fähig ist, unter einer Bedingung eines Wechselstroms zu arbeiten, auf der unteren und oberen Oberfläche der Gitteraufnahme (40) in Eins-zu-eins-Übereinstimmung mit den entsprechenden µLEDs, deren Subpixel ausgehärtet sind, steht, indem eine Chipelektrode angebracht wird oder die Elektrode wachsen gelassen wird und eine gewünschte Anzeigegröße mittels Laserschneiden ausgeschnitten wird,
wobei Schritt S1 die folgenden Schritte umfasst:
Schritt S11: Reinigen und Behandeln eines Substrats (11);
Schritt S12: Einbringen des Substrats (11) in eine Reaktionskammer einer Vorrichtung für physikalische Gasphasenabscheidung und Starten der Verdampfung einer Nanodraht-Pufferschicht (12), um eine Fehlpassung zwischen dem Substrat und dem Nanodraht in axialer Richtung zu lösen, wobei der Nanodraht während des Wachstums eine durch eine Fehlpassung zwischen dem Substrat und den Kristallstrukturen des Nanodrahtmaterials verursachte Spannung-Dehnung entlang einer seitlichen Oberfläche und in einer Richtung senkrecht zu einer Übergangsgrenzfläche freisetzt, sodass Materialien mit nicht übereinstimmenden Kristallstrukturen in Reihe angeschlossen werden und auf einfache Weise in radialer oder axialer Richtung wachsen können;
Schritt S13: Einbringen des mit einer Dünnschicht der Pufferschicht (12) bedeckten Substrats (11) in ein Multi-Chip-HVPE-Wachstumssystem, Starten des Wachsenlassens des Nanodrahts bei niedriger Temperatur, indem das Substrat als Boden herangezogen wird, wobei der Nanodraht so wächst, dass er von unten nach oben eine Struktur eines p-dotierten Nanodrahtendes mit elektropositiver Tendenz, eines p-dotierten Nanodrahtabschnitts, eines n-dotierten Nanodrahtabschnitts und eines n-dotierten Nanodrahtendes mit elektronegativer Tendenz ausbildet, und
Schritt S14: Kühlen der Struktur, um eine Probe zu entnehmen, sodass das Nanodrahtmaterial erhalten wird.

2. Verfahren zur Gestaltung einer µLED-Anzeige auf Nanodrahtbasis nach Anspruch 1, wobei das Nanodrahtmaterial eine homogene Struktur aufweist, die oberen und unteren Enden des Nanodrahtmaterials jeweils n- bzw. p-dotiert sind, zwei Endoberseiten jeweils eine elektronegative Tendenz bzw. eine elektropositive Tendenz aufweisen und an einer Mitte eines Übergangs zwischen n- und p-dotierten Homoübergängen eine Elektron-Loch-Rekombination erzeugt werden kann.

3. Verfahren zur Gestaltung einer µLED-Anzeige auf Nanodrahtbasis nach Anspruch 1, wobei ein Innendurchmesser des Nanodrahts im Bereich von 40 nm bis 60 nm liegt und eine Länge davon im Bereich von 300 nm und 400 nm liegt.

4. Verfahren zur Gestaltung einer µLED-Anzeige auf Nanodrahtbasis nach Anspruch 1, wobei es sich bei dem Nanodraht-Wachstumsmaterial für Subpixel mit unterschiedlichen Primärfarben jeweils um unterschiedliche Halbleiterverbindungen mit direkter Bandlücke aus den Gruppen III-V handelt.

5. Verfahren zur Gestaltung einer µLED-Anzeige auf Nanodrahtbasis nach Anspruch 1, wobei der lichthärtende Klebstoff ein transparentes Isoliermaterial ist.

6. Verfahren zur Gestaltung einer µLED-Anzeige auf Nanodrahtbasis nach Anspruch 1, wobei die Gitteraufnahme (40) aus einem transparenten Isoliermaterial besteht.

7. Verfahren zur Gestaltung einer µLED-Anzeige auf Nanodrahtbasis nach Anspruch 1, wobei die Elektrode (60) ein Material ist, das fähig ist, unter einer Bedingung eines Wechselstroms zu arbeiten, einschließlich, aber nicht beschränkt auf Graphen, PEDOT: PPS und Metalle wie Silber, Platin oder Gold.

## Revendications

1. Procédé de conception d'affichage µDEL à base de nanofils, comprenant : la croissance de matériaux de nanofils différents capables de générer trois couleurs primaires : rouge, vert et bleu sur un substrat (11) ; et **caractérisé en ce que** le procédé comprend en outre : la dissolution respective des différents matériaux de nanofils dans des adhésifs photodurcissables isolants et l'injection des mélanges dans différentes grilles d'un bassin de grilles (40), et la réalisation d'un durcissement ; et enfin, la disposition d'électrodes (60) sur des surfaces supérieure et inférieure du bassin de grilles (40) ;
le procédé de conception d'affichage µDEL à base de nanofils comprend spécifiquement les étapes suivantes :
Étape S1 : croissance du matériau de nanofils pour générer une source lumineuse pour trois couleurs primaires : rouge, vert et bleu ;
Étape S2 : dopage respectif du matériau de nanofils pour générer une source lumineuse pour trois couleurs primaires : rouge, vert et bleu dans les adhésifs photodurcissables et brassage complet des mélanges, et dispersion uniforme du matériau de nanofils dans les adhésifs photodurcissables pour obtenir un corps adhésif matériau de nanofils-adhésif photodurcissable complètement brassé ;
Étape S3 : injection respective du corps adhésif matériau de nanofils-adhésif photodurcissable complètement brassé de manière correspondante dans les grilles du bassin de grilles (40) correspondant à des sous-pixels des trois couleurs primaires : rouge, vert et bleu, et réalisation d'un photodurcissement, et découpe des corps adhésifs durcis débordant au moyen d'une découpe au laser après photodurcissement pour obtenir des µDELs durcies de sous-pixels ; et
Étape S4 : permission à une électrode capable de fonctionner sous une condition de courant alternatif d'être en correspondance biunivoque avec les µDEL durcies de sous-pixels correspondantes sur les surfaces supérieure et inférieure du bassin de grilles (40) par fixation d'une électrode de puce ou par croissance de l'électrode, et découpe selon une taille d'affichage souhaitée au moyen d'une découpe au laser ;
l'Étape S1 comprend les étapes suivantes :
Étape S11 : nettoyage et traitement d'un substrat (11) ;
Étape S12 : placement du substrat (11) dans une chambre de réaction d'un dispositif de dépôt physique en phase vapeur et démarrage de l'évaporation d'une couche tampon de nanofils (12) pour résoudre une inadéquation entre le substrat et le nanofil dans une direction axiale, dans lequel le nanofil se libère d'une contrainte-tension provoquée par une inadéquation entre le substrat et les réseaux cristallins du matériau de nanofils le long d'une surface latérale et d'une direction perpendiculaire à une interface de jonction pendant la croissance, de sorte que des matériaux avec des réseaux cristallins inadéquats puissent aisément être connectés en série et croître dans une direction radiale ou une direction axiale;
Étape S13 : placement du substrat (11) recouvert d'un film mince de la couche tampon (12) dans un système de croissance HVPE multi-puce, démarrage de la croissance du nanofil à basse température en prenant le substrat comme fond, dans lequel le nanofil croît pour devenir une structure extrémité de nanofil dopé p à tendance électropositive-nanofil dopé p-nanofil dopé n-extrémité de nanofil dopé n à tendance électronégative, de bas en haut ; et
Étape S14 : refroidissement de la structure pour retirer un échantillon afin d'obtenir le matériau de nanofils.

2. Procédé de conception d'affichage µDEL à base de nanofils selon la revendication 1, dans lequel le matériau de nanofils présente une structure homogène, les extrémités supérieure et inférieure du matériau de nanofils sont dopées n et p respectivement, deux sommets d'extrémité sont en tendance électronégative et en tendance électropositive respectivement, et une recombinaison trou-électron peut être générée au centre d'une jonction d'homojonctions n et p.

3. Procédé de conception d'affichage µDEL à base de nanofils selon la revendication 1, dans lequel un diamètre interne du nanofil est de 40 nm à 60 nm, et une longueur de celui-ci est de 300 nm à 400 nm.

4. Procédé de conception d'affichage µDEL à base de nanofils selon la revendication 1, dans lequel pour des sous-pixels présentant des couleurs primaires différentes, un matériau de croissance de nanofils consiste en des composés semi-conducteurs à bande interdite directe différents des groupes III-V.

5. Procédé de conception d'affichage µDEL à base de nanofils selon la revendication 1, dans lequel l'adhésif photodurcissable est un matériau isolant transparent.

6. Procédé de conception d'affichage µDEL à base de nanofils selon la revendication 1, dans lequel le bassin de grilles (40) est réalisé en un matériau isolant transparent.

7. Procédé de conception d'affichage µDEL à base de nanofils selon la revendication 1, dans lequel l'électrode (60) est un matériau capable de fonctionner en courant alternatif, incluant, mais sans s'y limiter, du graphène, du PEDOT: PPS, et des métaux argent, platine ou or.
